Europäisches Patentamt

European Patent Office

Office européen des brevets

(11) Veröffentlichungsnummer: **0 256 288**
**A2**

(12) # EUROPÄISCHE PATENTANMELDUNG

(21) Anmeldenummer: **87109773.9**

(51) Int. Cl.⁴: **H03H 17/02**

(22) Anmeldetag: **07.07.87**

(30) Priorität: **14.08.86 DE 3627677**

(43) Veröffentlichungstag der Anmeldung:
**24.02.88 Patentblatt 88/08**

(84) Benannte Vertragsstaaten:
**DE FR GB IT SE**

(71) Anmelder: **Blaupunkt-Werke GmbH**
**Robert-Bosch-Strasse 200**
**D-3200 Hildesheim(DE)**

(72) Erfinder: **Vogelsang, Ulrich, Dr.Ing.**
**Asternweg 10 b**
**D-3200 Hildesheim(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Verfahren und Anordnung zur frequenzabhängigen Beeinflussung eines Signals.**

(57) Bei einem Verfahren zur frequenzabhängigen Beeinflussung eines Signals wird das Signal nacheinander mehrmals gefiltert und parallel dazu mehrmals verzögert. Das jeweils gefilterte Signal wird mit je einem zugefuhrten Faktor multipliziert und zum entsprechend verzögerten Signal hinzuaddiert. Bei einer Anordnung zur Durchführung des Verfahrens sind für die Filterung des Signals digitale Filter mit endlicher Sprungantwort und für die Verzögerung des Signals digitale Allpässe vorgesehen. Die Ausgänge der Filter sind über jeweils einen Multiplizierer mit jeweils einem dem entsprechenden Allpaß nachgeschalteten Addierer verbunden.

Fig.1

EP 0 256 288 A2

## Verfahren und Anordnung zur frequenzabhängigen Beeinflussung eines Signals

Die Erfindung geht aus von einem Verfahren nach der Gattung des Hauptanspruchs.

In der Nachrichtentechnik werden verschiedene Zwecke, insbesondere für die Frequenzkompensation eines Übertragungsweges (equalizing) Filteranordnungen eingesetzt, die aus mehreren Teilfiltern bestehen und auch Filterbänke genannt werden. Diese Filteranordnungen nehmen eine Aufteilung von Signalen in mehrere Komponenten unterschiedlicher Frequenzbereiche vor. Dabei sind verschiedene Forderungen zu beachten, wie beispielsweise möglichst geringer technischer Aufwand und möglichst geringe Amplituden-und Phasenverzerrungen bei der spektralen Zerlegung.

Das erfindungsgemäße Verfahren mit den kennzeichnenden Merkmalen des Hauptanspruchs hat bei einer Realisierung mit einem Signalprozessor den Vorteil, daß die Anzahl von Rechen-und Speichervorgängen so gering ist, daß relativ komplexe Filteranordnungen mit zur Verfügung stehenden Signalprozessoren verwirklicht werden können. Dabei ist eine weitgehend beliebige, besonders vorteilhafte Zerlegung in Teilbänder möglich, insbesondere solcher mit konstanter relativer Bandbreite. Auch bei einer schaltungstechnischen Realisierung ergibt sich ein verhältnismäßig geringer Aufwand an Speichern, Multiplizierern und Addierern.

Durch die in den Unteransprüchen aufgeführten Maßnahmen sind vorteilhafte Weiterbildungen und Verbesserungen des im Hauptanspruch angegebenen Verfahrens möglich.

Ein Ausführungsbeispiel der Erfindung ist in der Zeichnung an Hand mehrerer Figuren dargestellt und in der nachfolgenden Beschreibung näher erläutert. Es zeigt:

Fig. 1 eine schematische Darstellung des Ausführungsbeispiels,

Fig. 2 Übertragungsfaktoren der bei dem Ausführungsbeispiel nach Fig. 1 verwendeten Filter in Abhängigkeit der Frequenz und

Fig. 3 ein an sich bekanntes Beispiel für einen bei dem Ausführungsbeispiel verwendetes Filter.

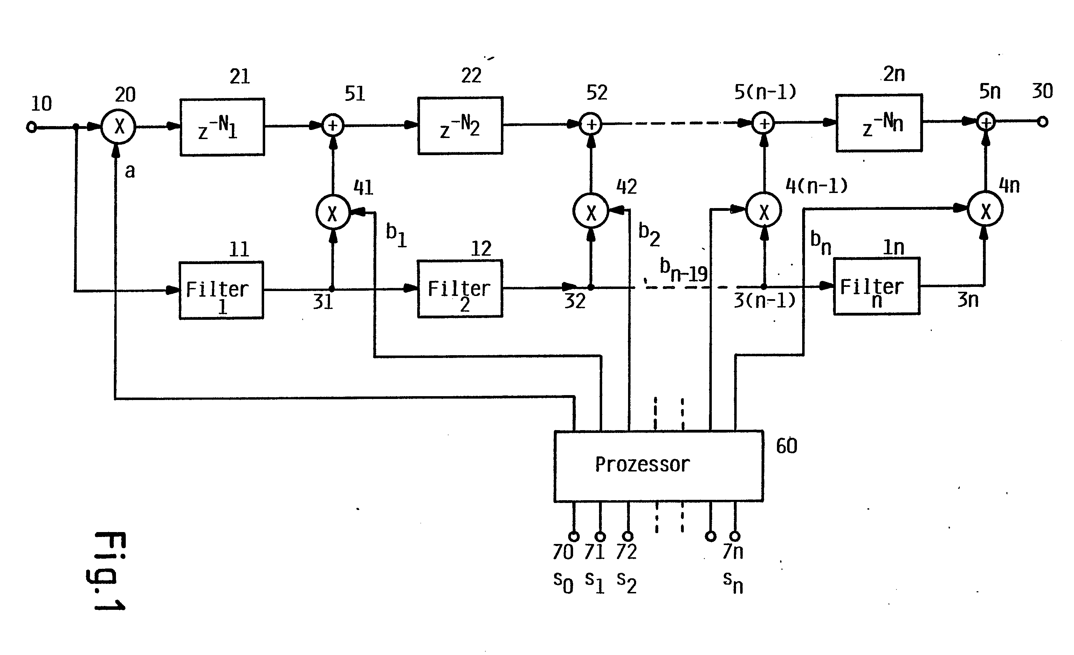

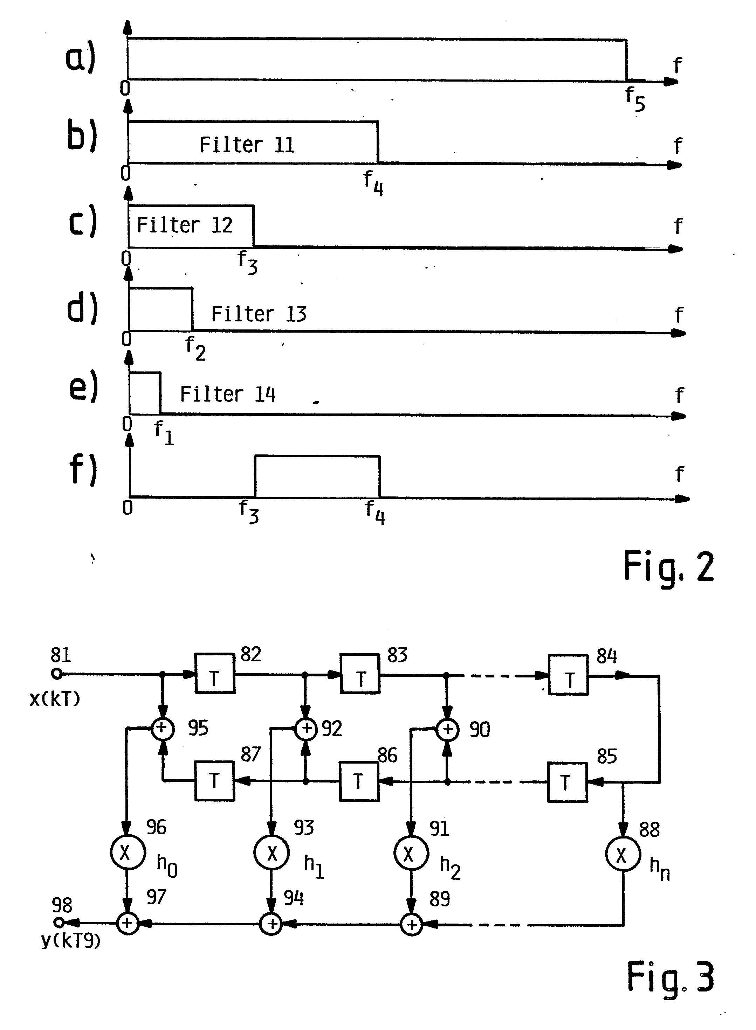

Je nach Realisierung der erfindungsgemäßen Filteranordnung können die Figuren 1 und 3 als Flußdiagramme für in einem Signalprozessor gespeicherte Programme oder als Blockschaltbilder einer schaltungstechnischen Realisierung betrachtet werden.

Die Anordnung nach Fig. 1 besteht aus einer Reihe von linearphasigen Transversalfiltern 11, 12 ... 1n, zu denen eine Reihenschaltung aus Allpässen 21, 22 ... 2n parallelgeschaltet ist. Der Eingang des ersten Filters 11 ist mit dem Eingang 10 der Filteranordnung verbunden, während der Eingang des ersten Allpasses 21 über einen Multiplizierer 20 an den Eingang 10 angeschlossen ist. Die Ausgänge 31, 32 ... 3n der Filter 11, 12 ... 1n sind einerseits an den Eingang des folgenden Filters und andererseits an den Eingang je eines Multiplizierers 41, 42 ... 4(n-1), 4n angeschlossen. Die Ausgangssignale der Multiplizierer werden in Addierern 51, 52 ... 5(n-1), 5n zu den Ausgangssignalen der jeweiligen Allpässe 21, 22 ... 2n addiert. Der Ausgang des letzten Addierers 5n bildet den Ausgang 30 der gesamten Anordnung.

Den Multiplizierern 20, 41, 42 ... 4(n-1), 4n werden von einem Prozessor 60 Faktoren a, $b_1$, $b_2$ ... $b(n-1)$, $b_n$ zugeführt, welche aus Steuerwerten $s_0$ bis $s_n$ ermittelt werden. Die Steuerwerte stellen jeweils einen für einen Frequenzbereich einzustellenden Übertragungsfaktor oder Signale dar, aus denen die Übertragungsfaktoren mittels Rechnungen gewonnen werden, und werden den Eingängen 70 und 71 bis 7n des Prozessors 60 zugeführt.

Im folgenden wird bei der Erläuterung der Funktion der Anordnung nach Fig. 1 auf die in Fig. 2 dargestellten Diagramme Bezug genommen. Dabei ist angenommen, daß bei der Anordnung nach Fig. 1 vier Tiefpaßfilter vorgesehen sind, deren obere Grenzfrequenzen jeweils der Hälfte der Grenzfrequenz des vorangegan genen Filters entsprechen. Zeile a) der Fig. 2 stellt die Charakteristik eines Allpasses dar, dessen Übertragungsfaktor innerhalb des in Frage kommenden Frequenzbereichs konstant ist. Zeile b) stellt den Übertragungsfaktor des ersten Tiefpaßfilters dar, während die Zeilen c), d) und e) die Verläufe der weiteren Tiefpaßfilter zeigen. Durch die Wirkung der Addierer 51, 52 ... 5(n-1), 5n gehen diejenigen dargestellten Übertragungsfaktoren in den resultierenden Frequenzgang ein, für welche die zugeführten Faktoren ungleich null sind.

Soll beispielsweise der in Zeile f) dargestellte Frequenzgang eingestellt werden, so sind die Faktoren für die Ausgangssignale der Filter 13 und 14 gleich null, was der Zeichnung ohne weiteres zu entnehmen ist. Ferner ist ebenfalls der Faktor a = 0, damit auch der Frequenzgang zwischen $f_4$ und $f_5$ zu null wird. Von dem Frequenzgang des Filters 11 ist dann lediglich derjenige des Filters 12 abzuziehen, damit auch der Frequenzbereich zwischen null und $f_3$ zu null wird. Es verbleibt somit ein Durchlaßbereich der gesamten Anordnung zwischen $f_3$ und $f_4$. Die Größe des Übertragungsfaktors in diesem Frequenzbereich kann mit dem Faktor $b_1$ eingestellt werden, wobei sicherzustellen ist, daß für alle Werte von $b_1$ $b_2 = -b_1$ gilt.

In ähnlicher Weise können für die weiteren Frequenzbereiche die Faktoren ermittelt werden, worauf sich durch lineare Überlagerung die Übertragungsfaktoren bei hinreichender Nachbarkanaldämpfung für die einzelnen Frequenzbereiche weitgehend unabhängig voneinander einstellen lassen. Die erfindungsgemäße Anordnung kann, wie im Zusammenhang mit den Figuren 1 und 2 erläutert, mit Tiefpaßfiltern verwirklicht werden. Es können jedoch auch Hochpaßfilter verwendet werden, deren Grenzfrequenz von Mal zu Mal steigt.

Das im Zusammenhang mit Fig. 1 erläuterte Ausführungsbeispiel kann vielfältig verwendet werden. Eine bevorzugte Anwendung ist die Entzerrung von Audiosignalen, welche einem Magnetband entnommen werden. Hierbei ist die bei dem Ausführungsbeispiel gewählte Aufteilung des gesamten Frequenzbandes in Teilbänder gleicher relativer Bandbreite besonders vorteilhaft. Die Steuergrößen $s_0$ bis $s_n$ können per Hand eingestellt oder aus einem Speicher abgerufen werden, beispielsweise als voreingestellte Entzerrerkennlinie. Es ist ferner möglich, die Steuergrößen aus einem der Anordnung zugeführten Signal abzuleiten, wodurch ein adaptives Verhalten der Anordnung erreicht wird.

Neben linearphasigen Transversalfilter eignen sich auch andere digitale Filter mit endlicher Sprungantwort (FIR-Filter). In diesem Fall müssen die einfachen Allpaß-Verzögerungen 21, 22 ... 2n durch geeignet gewählte digitale Allpässe ersetzt werden. Bei linearphasigen Transversalfiltern ergeben sich jedoch die in Fig. 1 dargestellten besonders einfachen Allpässe.

Fig. 3 zeigt ein linearphasiges Transversalfilter in detaillierterer Darstellung, wie es bei der Anordnung nach Fig. 1 in vorteilhafter Weise verwendet werden kann. Dem Eingang 81 wird das zu filternde digitale Signal x(kT) zugeführt. Dabei bedeutet T die Abtastperiode und k die jeweilige Ordnungszahl der Abtastperiode. Das Eingangssignal wird 2Nmal um eine Abtastperiode T verzögert. Zur besseren Über sicht sind lediglich die Verzögerungen 82, 83, 84, 85, 86, 87 dargestellt. In digitalen Schaltungen können derartige Verzögerungen in einfacher Weise mit Hilfe von getakteten Registern verwirklicht werden. Das unverzögerte Eingangssignal x(kT) sowie das um T bis 2NT verzögerte Eingangssignal wird mit verschiedenen Koeffizienten, welche die Filtercharakteristik bestimmen, jeweils bewertet und nachfolgend zu dem Ausgangssignal y(kT) zusammengefaßt.

Durch die gerade Anzahl von Verzögerungen ergibt sich zwischen den Verzögerungen 84 und 85 ein um eine mittlere Zeit verzögertes Signal, das mit Hilfe eines Multiplizierers 88 mit den Koeffizienten $h_N$ bewertet und dem Addierer 89 zugeführt wird. Die jeweils um n Abtastperioden weniger und um n Abtastperioden mehr verzögerten Signale werden jeweils in einem Addierer zusammengefaßt, in einem Multiplizierer mit dem Koeffizienten $h_{(N - n)}$ bewertet und über einen Addierer dem Ausgangssignal zugefügt. Dieses ist beispielhaft mit den Addierern 90, 92, 95, den Multiplizierern 91, 93, 96 und den Addierern 89, 94, 97 dargestellt. Dabei ist n = 1 ... N. Am Ausgang 28 steht das Ausgangssignal y(kT) zur Verfügung. Im Zusammenhang mit Fig. 3 beschriebene Filter sind an sich bekannt und sind beispielsweise in Lücker, Raimund: Grundlagen digitaler Filter beschrieben.

Im Zusammenhang mit Fig. 1 wurde die Steuerung der Übertragungsfaktoren innerhalb der einzelnen Frequenzbereiche beschrieben. Da die Koeffizienten $h_0$ bis $h_N$, welche den Multiplizierern 96, 93, 91, 88 (Fig. 3) zugeführt werden, u. a. die Grenzfrequenzen beeinflussen, ist damit eine Steuerung der Grenzen der Frequenzbereiche bei der anordnung nach Fig. 1 möglich.

Ohne die Erfindung zu verlassen, können die Multiplizierer 41 bis 4n (Fig. 1) auch dadurch ersetzt werden, daß die Koeffizienten $h_0$ bis $h_N$ mit dem für das jeweilige Filter vorgesehenen Faktor $b_1$, $b_2$ oder $b_n$ multipliziert und die entstehenden Produkte den Multiplizierern 96, 93, 91, 88 (Fig. 3) zugeführt werden.

Dadurch erhöht sich zwar die Anzahl der Multiplizierer bzw. - bei der Realisierung mit einem Signalprozessor - die Anzahl der Multiplikationen, die Multiplikation der Faktoren mit den Koeffizienten kann jedoch wesentlich langsamer bzw. in größeren Zeitabständen erfolgen als Multiplikationen des zu filternden Signals, die innerhalb jeweils einer Abtastperiode T abgeschlossen sein müssen.

**Ansprüche**

1. Verfahren zur frequenzabhängigen Beeinflussung eines Signals, dadurch gekennzeichnet, daß das Signal nacheinander mehrmals gefiltert und parallel dazu mehrmals verzögert wird, daß das jeweils gefilterte Signal mit je einem zugefuhrten Faktor multipliziert und zum entsprechend verzögerten Signal hinzuaddiert wird.

2. Verfahren nach Anspruch 1, dadurch gekennzeichnet, daß das Signal mit von Mal zu Mal geringerer Grenzfrequenz tiefpaßgefiltert wird.

3. Verfahren nach Anspruch 1, dadurch gekennzeichnet, daß das Signal mit von Mal zu Mal höherer Grenzfrequenz hochpaßgefiltert wird.

4. Verfahren nach einem der vorhergehenden Ansprüche, dadurch gekennzeichnet,

daß das ungefilterte Signal mit einem weiteren Faktor multipliziert wird.

5. Verfahren nach einem der vorhergehenden Ansprüche, dadurch gekennzeichnet,

daß die Faktoren aus zugeführten Steuergrößen derart errechnet werden, daß sich bei Änderung einer jeweils einem Frequenzbereich zugeordneten Steuergröße im wesentlichen nur in diesem Frequenzbereich eine Änderung der Beeinflussung des Signals ergibt.

6. Anordnung zur Durchführung des Verfahrens nach einem der vorhergehenden Ansprüche, dadurch gekennzeichnet,

daß für die Filterung des Signals digitale Filter (11, 12 ... 1n) mit endlicher Sprungantwort und fur die Verzögerung des Signals digitale Allpässe (21, 22 ... 2n) vorgesehen sind und

daß die Ausgänge der Filter (11, 12 ... 1n) über jeweils einen Multiplizierer (41, 42 ... 4n) mit jeweils einem dem entsprechenden Allpaß (21, 22 ... 2n) nachgeschalteten Addierer (51, 52 ... 5n) verbunden sind.

7. Anordnung nach Anspruch 6 , dadurch gekennzeichnet,

daß die Filter (11, 12 ... 1n), die Multiplizierer 41, 42 ... 4n) und die Addierer (51, 52 ... 5n) von mindestens einem entsprechend programmierten Signalprozessor gebildet sind.

8. Anordnung nach einem der Ansprüche 6 bis 7, dadurch gekennzeichnet,

daß Sperrdämpfung, Durchlaßdämpfung, Sperrfrequenz, Durchlaßfrequenz und Abtastfrequenz derart gewählt sind, daß bei vorgegebener Struktur der Teilfilter eine Anzahl von Filterkoeffizienten gleich null ist.

9. Anordnung nach einem der Ansprüche 6 oder 7, dadurch gekennzeichnet,

daß die Koeffizienten der Teilfilter durch Skalierung aus vorgegebenen Übertragungsfunktionen $H\mu(z)$ mittels Transformation $z: = z^K$ gewonnen werden.

10. Anordnung nach einem der Ansprüche 6 oder 7, dadurch gekennzeichnet,

daß die Frequenzaufteilung steuerbar ist.

Fig.1

Fig. 2

Fig. 3